(19) Europäisches Patentamt / European Patent Office / Office européen des brevets

(11) **EP 4 355 063 B1**

(12) **FASCICULE DE BREVET EUROPEEN**

(45) Date de publication et mention de la délivrance du brevet:
**01.04.2026 Bulletin 2026/14**

(51) Classification Internationale des Brevets (IPC):
*H10N 10/01* (2023.01)  *B22F 10/28* (2021.01)
*B33Y 10/00* (2015.01)  *B33Y 80/00* (2015.01)
*B22F 7/08* (2006.01)  *H10N 10/817* (2023.01)
*B22F 7/00* (2006.01)

(21) Numéro de dépôt: **23203612.9**

(22) Date de dépôt: **13.10.2023**

(52) Classification Coopérative des Brevets (CPC):
(C-Sets disponibles)
**H10N 10/01; B22F 7/008; B22F 7/08; B22F 10/28;
B33Y 10/00; B33Y 80/00; H10N 10/817;**
B22F 2005/005; B22F 2998/00; Y02P 10/25

(Cont.)

(54) **PROCEDE DE METALLISATION D'UNE STRUCTURE THERMOELECTRIQUE**

VERFAHREN ZUR METALLISIERUNG EINER THERMOELEKTRISCHEN STRUKTUR

METHOD FOR METALLIZING A THERMOELECTRIC STRUCTURE

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **14.10.2022 FR 2210614**

(43) Date de publication de la demande:
**17.04.2024 Bulletin 2024/16**

(73) Titulaire: **Commissariat à l'Energie Atomique et
aux Energies
Alternatives
75015 Paris (FR)**

(72) Inventeurs:
• **SAVELLI, Guillaume
38054 Grenoble Cedex 09 (FR)**
• **BAUDRY, Maxime
38054 Grenoble Cedex 09 (FR)**

• **ROUX, Guilhem
38054 Grenoble Cedex 09 (FR)**

(74) Mandataire: **Santarelli
Tour Trinity
1 bis Place de la Défense
92400 Courbevoie (FR)**

(56) Documents cités:
**EP-A1- 3 985 745      WO-A1-2020/066948
CN-B- 106 384 779      US-A1- 2017 069 817**

• **EL-DESOUKY AHMED ET AL: "Rapid processing
and assembly of semiconductor thermoelectric
materials for energy conversion devices",
MATERIALS LETTERS, vol. 185, 1 August 2016
(2016-08-01), pages 598 - 602, XP029810531,
ISSN: 0167-577X, DOI: 10.1016/
J.MATLET.2016.07.152**

EP 4 355 063 B1

(52) Classification Coopérative des Brevets (CPC):
(Cont.)

C-Sets
B22F 2998/00, B22F 10/25

**Description**

**DOMAINE TECHNIQUE**

La présente invention se rapporte au domaine général des modules thermoélectriques. L'invention concerne un procédé de fabrication de structures thermoélectriques. L'invention trouve des applications dans de nombreux domaines industriels, et notamment pour les applications ayant besoin de générateurs thermoélectriques, où un gradient thermique est disponible (exemple transports, industries, etc.), les applications de générateur thermoélectrique à radioisotope, les applications Peltier ou encore les applications de capteurs thermiques.

L'invention est particulièrement intéressante puisqu'elle permet de former des structures/dispositifs thermoélectriques présentant de faibles résistivités.

**ÉTAT DE LA TECHNIQUE ANTÉRIEURE**

Généralement, les modules thermoélectriques (TE) comprennent un ensemble de premiers plots en un matériau thermoélectrique d'un premier type de conductivité et un ensemble de deuxièmes plots en un matériau thermoélectrique d'un deuxième type de conductivité. Par exemple, le premier matériau est un matériau de type N (i.e. à conductivité de type N) et le deuxième matériau est un matériau de type P (i.e. à conductivité de type P).

Les plots sont connectés électriquement en série et thermiquement en parallèle. Les plots sont reliés entre eux par des éléments métalliques. Les jonctions thermoélectriques sont aussi appelées jonctions NP. Les plots sont maintenus par des substrats en céramique disposés de part et d'autre des ensembles de plots.

Les performances électriques d'un dispositif TE en mode générateur sont données par :

- une résistance électrique interne $R_{int}$ définie selon (1) :

$$R_{int} = N \times \rho_{np} \times L / A + R_c + R_{met} \quad (1)$$

avec N le nombre de jonctions np, $\rho_{np}$ la résistivité électrique des matériaux NP , L la longueur d'une ligne ou épaisseur d'un plot, A la section d'une ligne ou d'un plot, $R_c$ la résistance totale des contacts et $R_{met}$ la résistance totale des jonctions métalliques

- une puissance électrique utile Pu définie selon (2) :

$$Pu = V_{oc}^2 / 4R_{int}$$

avec $V_{oc}$ la tension générée par le module TE.

Ainsi, pour disposer d'une puissance élevée, il faut avoir une résistance électrique interne faible, et donc diminuer la contribution de la résistance totale des contacts $R_c$ et de la résistance totale des jonctions métalliques Rmet.

Classiquement, la fabrication des modules TE est généralement réalisée à partir des étapes suivantes : fabrication des matériaux TE (frittage), mise en forme des plots, métallisation des plots, assemblage avec les substrats.

Les connections métalliques sont réalisées directement sur les substrats, par exemple par la technique dite du cuivre direct (ou DBC pour 'Direct Bonding Copper'), puis brasage et pressage avec les plots.

Cependant, ce procédé de fabrication est relativement complexe et limite beaucoup la géométrie et la modularité du dispositif thermoélectrique fabriqué.

Il existe également des modules TE sans substrat, aussi appelés "modules squelettes". Ces modules n'ont donc pas de perte thermique due aux substrats. Cependant, ils ne peuvent être en contact avec des surfaces conductrices électriquement.

Il est également possible d'utiliser des plots TE réalisés à partir de plusieurs matériaux TE. Ces plots dits segmentés permettent de s'accommoder d'une plus grande différence de température aux extrémités du module car les matériaux utilisés sont généralement optimisés pour des gammes de température différentes.

Le document WO 2020/066948 A1 décrit un procédé de fabrication d'un module thermoélectrique facilitant l'opération d'agencement des éléments thermoélectriques, ce procédé pouvant être réalisé en un nombre limité d'étapes.

**EXPOSÉ DE L'INVENTION**

Un but de la présente invention est de proposer un procédé de fabrication de structures thermoélectriques, simple à mettre œuvre, et permettant de fabriquer des structures thermoélectriques ayant de bonnes propriétés électriques (notamment, une faible résistance de contact) et/ou de bonnes propriétés thermiques.

Pour cela, la présente invention propose un procédé de fabrication d'une structure thermoélectrique comprenant les étapes suivantes :

a) fournir un substrat, recouvert complètement ou localement, par une couche métallique,
b) former un élément thermoélectrique en un matériau thermoélectrique, sur la couche métallique, par fabrication additive, de préférence par frittage sélectif par laser (SLS) ou fusion laser sur lit de poudre (FLLP).

Le procédé selon l'invention comprend, en outre, une étape c) ultérieure au cours de laquelle on retire le substrat, moyennant quoi on obtient une structure thermoélectrique comprenant la couche métallique et l'élément thermoélectrique.

L'invention se distingue fondamentalement de l'art antérieur par la mise en œuvre d'une étape au cours de laquelle la fonctionnalisation (métallisation) de l'élément thermoélectrique (par exemple un plot thermoélectrique) est réalisée lors du procédé de fabrication additive.

Ceci conduit non seulement à une diminution conséquente du nombre d'étapes et donc à une simplification du procédé par rapport aux procédés de l'art antérieur, mais aussi à un gain de temps considérable et à une diminution des coûts.

La métallisation obtenue présente une bonne tenue mécanique et de bonnes propriétés de conduction électrique et/ou thermique.

De préférence, la technique de fabrication additive est une technique de fusion laser sur lit de poudre (FLLP ou PBF pour "Powder Bed Fusion" en terminologie anglo-saxonne) ou une technique de Frittage Sélectif par Laser (FLS ou SLS pour "Selective Laser Sintering"). Le procédé comporte une étape c) ultérieure au cours de laquelle on retire le substrat, moyennant quoi on obtient une structure thermoélectrique comprenant la couche métallique et l'élément thermoélectrique.

Avantageusement, l'élément thermoélectrique est une pièce ayant la forme d'un peigne délimitant une base et une pluralité de branches, sensiblement parallèles entre elles, s'étendant sensiblement orthogonalement à partir de la base, la pluralité de branches ayant une première extrémité et une deuxième extrémité, la première extrémité étant reliée à la base, et la deuxième extrémité de la pluralité de branches étant en contact avec la couche métallique.

Avantageusement, l'élément thermoélectrique est un plot, ayant une base et une hauteur.

Selon cette variante avantageuse, la couche métallique peut avoir une même surface que la surface de la base du plot. Toujours selon cette variante avantageuse, la couche métallique peut avoir une surface supérieure à la surface de la base du plot. Avantageusement, lors de l'étape a), la couche métallique recouvre localement le substrat de manière à former une pluralité d'ilots et un élément thermoélectrique ou plusieurs éléments thermoélectriques sont déposés sur chaque ilot lors de l'étape b). Avantageusement, le matériau thermoélectrique est Si, SiGe, $Bi_2Te_3$, Half-Heusler ou Skutterudites.

Avantageusement, le substrat est de l'acier 316L, l'aluminium, le titane, un alliage CuZr, une céramique ou du graphite.

Avantageusement, la couche métallique est en un matériau choisi parmi Al, Ti, Cu, Au et Ni.

Le procédé présente de nombreux avantages :

- il présente un nombre faible d'étapes,
- il est simple et économique,
- il autorise une grande modularité de forme et de conception du dispositif thermoélectrique fabriqué,
- les plots peuvent avoir des formes complexes.

La structure thermoélectrique obtenue par un tel procédé comprend successivement :

- éventuellement un substrat,
- une couche métallique, par exemple en Al, Ti, Cu, Au ou Ni,
- un ou plusieurs éléments thermoélectriques, de préférence des plots, disposés sur la couche métallique.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

Les Fig. 1A, Fig. 1B et Fig. 1C représentent, de manière schématique et en coupe, les différentes étapes d'un procédé de fabrication d'une structure thermoélectrique selon un premier mode de réalisation de l'invention.

Les Fig. 2A, Fig. 2B, Fig. 2C et Fig. 2D représentent, de manière schématique et en coupe, les différentes étapes d'un procédé de fabrication d'un dispositif thermoélectrique selon un mode de réalisation hors invention.

Les Fig. 3A, Fig. 3B, Fig. 3C, Fig. 3D et Fig. 3E représentent, de manière schématique et en coupe, les différentes étapes d'un procédé de fabrication d'un dispositif thermoélectrique selon un deuxième mode de réalisation de l'invention.

Les Fig. 4A, Fig. 4B, Fig. 4C et Fig. 4D représentent, de manière schématique et en coupe, les différentes étapes d'un procédé de fabrication d'un dispositif thermoélectrique selon un mode de réalisation hors invention.

Les Fig. 5A, Fig. 5B et Fig. 5C représentent, de manière schématique et en coupe, les différentes étapes d'un procédé de fabrication d'une structure thermoélectrique selon un troisième mode de réalisation de l'invention.

Les Fig. 6A, Fig. 6B, Fig. 6C et Fig. 6D représentent, de manière schématique et en coupe, les différentes étapes d'un procédé de fabrication d'une structure thermoélectrique selon un quatrième mode de réalisation de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que "dessus", "dessous", etc. d'une structure s'appliquent en considérant que la structure est orientée de la façon illustrée sur les figures.

## EXPOSÉ DÉTAILLÉ DE MODES DE RÉALISATION PARTICULIERS

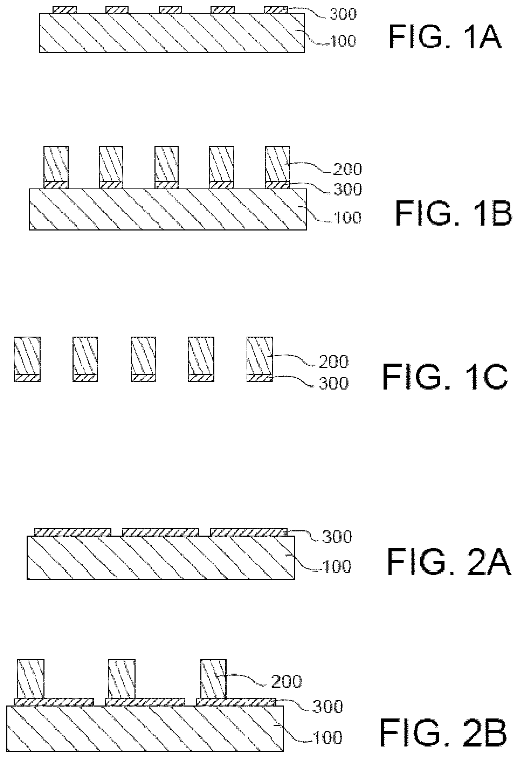

Bien que cela ne soit aucunement limitatif, l'invention est particulièrement intéressante pour des applications ayant besoin de générateurs thermoélectriques (GTE ou TEG pour "ThermoElectric Generator"), où un gradient thermique est disponible (exemple transports, industries, etc.), les applications de générateur thermoélectrique à radioisotope (GTR ou RTG pour "Radio-isotope ThermoElectric Generators") en particulier pour SiGe, les applications Peltier ou encore les applications de capteurs thermiques. Comme représenté sur les Fig. 1A à 1C, 3A à 3C, 5A à 5C, 6A à 6D, le procédé de fabrication d'une structure thermoélectrique selon l'invention comprend les étapes suivantes :

a) fournir un substrat 100, recouvert complètement ou localement, par une couche métallique 300,
b) former un élément thermoélectrique 200 en un matériau thermoélectrique, sur la couche métallique 300, par fabrication additive, de préférence par SLS ou FLLP, moyennant quoi on obtient une structure thermoélectrique comprenant le substrat 100 recouvert successivement par la couche métallique 300 et par l'élément thermoélectrique (200), et
c) retirer le substrat 100, moyennant quoi on obtient une structure thermoélectrique comprenant la couche métallique 300 et l'élément thermoélectrique (200).

Le substrat 100 fourni à l'étape a) peut être un plateau ou un sur-plateau.

Dans les machines de fabrication additive, les sur-plateaux se fixent directement sur les plateaux, et permettent, non seulement, d'obtenir des épaisseurs plus fines (entre 200 $\mu$m et quelques millimètres), mais également, d'augmenter la nature des matériaux utilisables. Le sur-plateau est, avantageusement, en céramique.

Le substrat 100 est, par exemple, en un métal (par exemple Al, Ti, Cu, Au ou Ni), en un alliage métallique, en un matériau semi-conducteur, en céramique ou en graphite. Par exemple, il est en acier 316L, Aluminium, Titane, CuZr, céramique ou graphite.

Le substrat 100 peut avoir une épaisseur allant de quelques centaines de micromètres à quelques centimètres, et de préférence de quelques centaines de micromètres à quelques millimètres.

Le substrat 100 fourni à l'étape a) est recouvert par une couche métallique 300 (aussi appelée couche d'accroche) en un troisième matériau.

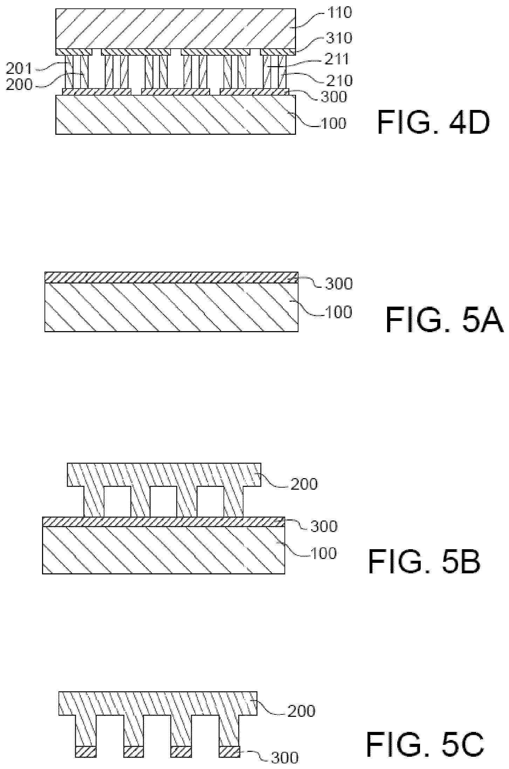

La couche d'accroche 300 peut être déposée, par exemple, par dépôt Physique en phase Vapeur (ou PVD pour "Physical Vapor Deposition" en anglais), évaporation, pulvérisation. La couche d'accroche 300 peut recouvrir localement (Fig. 1A, 2A, 3A, 4A, 6A) ou complètement (Fig. 5A) le substrat 100. Par exemple, la couche d'accroche métallique 300 forme des ilots à la surface du substrat 100.

Pour obtenir une couche métallique 300 recouvrant localement le substrat 100, il est possible de réaliser un dépôt localisé de cette couche. Alternativement, il est possible de réaliser un dépôt pleine plaque d'une couche continue suivi d'une étape au cours de laquelle on retire une partie de la couche continue, par exemple par gravure, pour former les ilots.

La couche d'accroche métallique 300 est en un matériau différent de celui du substrat 100.

La couche d'accroche 300 est, par exemple, en métal ou en un alliage métallique. De préférence, le métal est choisi parmi Al, Ti, Cu, Au et Ni. Plusieurs couches peuvent être superposées, par exemple, il peut s'agit d'un bicouche ou d'un tricouche. On pourra choisir un tricouche formé d'une couche de cuivre, d'une couche de nickel et d'une couche d'or. À titre illustratif et non limitatif, il est possible de choisir un tricouche formé de Cu (par exemple 200 nm) + Ni (par exemple 5 $\mu$m) + Au (par exemple 10 nm).

Après la formation de la couche d'accroche 300, une étape de recuit peut être réalisée.

Lors de l'étape b), l'élément thermoélectrique 200 est formé sur la couche d'accroche métallique 300. Il est directement en contact avec cette couche d'accroche 300. L'élément thermoélectrique 200 est en un deuxième matériau. Le deuxième matériau est, de préférence, choisi parmi Si, SiGe, MnSi, $Bi_2Te_3$, Half-Heusler et Skutterudites. Les Skutterudites sont des espèces minérales composées d'arséniure de cobalt et de nickel de formule $(Co, Ni)As_{3-x}$ avec des traces de S, Bi, Cu, Pb, Zn, Ag, Fe et Ni.

L'élément thermoélectrique 200 peut être à conductivité de type N pour favoriser le déplacement des électrons (c'est-à-dire que le matériau qui le compose est à coefficient Seebeck strictement négatif) ou à conductivité de type P pour favoriser le déplacement des trous (c'est-à-dire que le matériau qui le compose est à coefficient Seebeck strictement positif).

Par exemple, le matériau thermoélectrique dopé de type N est un alliage silicium-germanium (SiGe) dopé par du phosphore ou du polysilicium dopé de type N. Le dopant de type N peut être du phosphore ou de l'arsenic.

Par exemple, le matériau de type P est un alliage silicium-germanium (SiGe) dopé par du bore ou encore du polysilicium dopé de type P. Le dopant de type P est préférentiellement du bore.

Le dopant est, avantageusement, intégré directement dans la poudre de base.

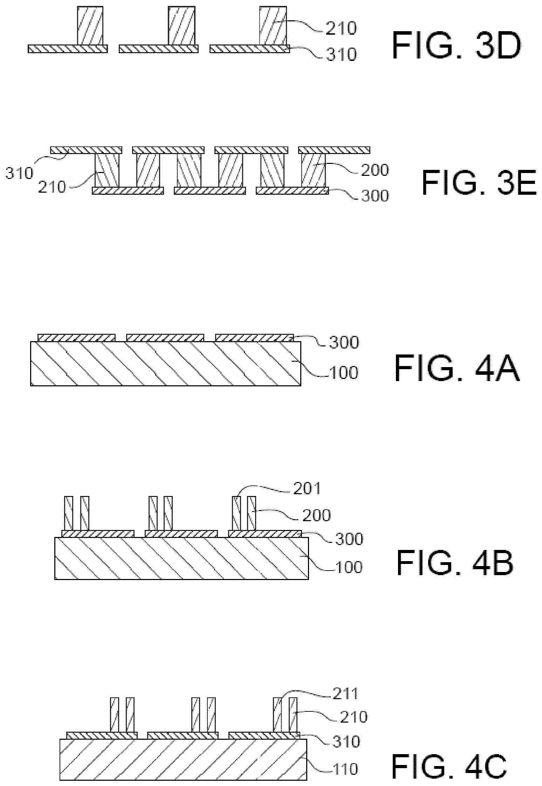

Un élément thermoélectrique 200 (Fig. 1B, 2B, 3B, 6B) ou plusieurs éléments thermoélectriques 200, 201 peuvent être formés sur chaque ilot (Fig. 4B).

L'élément thermoélectrique 200 déposé à l'étape b) est obtenu par fabrication additive. Le procédé consiste à déposer le matériau en plusieurs passes successives sur la couche d'accroche 300. À l'issue des dépôts successifs, on obtient l'élément thermoélectrique. Le substrat peut être un plateau ou un sur-plateau.

La technique de fabrication additive est, de préférence, une technique de fusion laser sur lit de poudre (FLLP ou PBF pour "Powder Bed Fusion" en terminologie anglo-saxonne) ou une technique de Frittage Sélectif par Laser ("SLS" qui est l'acronyme pour "Selective Laser Sintering") selon la terminologie anglo-saxonne.

Les procédés FLLP consistent à faire fondre certaines régions d'un lit de poudre, par exemple au moyen d'un faisceau laser.

Dans le procédé SLS, les poudres sont frittées. Les matériaux des poudres ne passent pas en phase liquide.

Cependant, d'autres techniques de fabrication additive peuvent être envisagées, comme le "Cold Spray", "Electron Beam Melting", etc.

L'élément thermoélectrique 200 déposé à l'étape b) peut prendre plusieurs formes. Selon une première variante de réalisation avantageuse, l'élément thermoélectrique 200 est une pièce en forme de peigne (Fig. 5B).

La pièce a la forme d'un peigne délimitant une base et une pluralité de branches, sensiblement parallèles entre elles, s'étendant sensiblement orthogonalement à partir de la base. La pluralité de branches a une première extrémité et une deuxième extrémité. La première extrémité est reliée à la base, et la deuxième extrémité est en contact avec la couche d'accroche métallique 300.

Par "sensiblement orthogonal", on entend "orthogonal" ou "orthogonal à plus ou moins 10° de tolérance".

Par "sensiblement parallèle", on entend "parallèle" ou "parallèle à plus ou moins 10° de tolérance".

Selon une autre variante de réalisation, l'élément thermoélectrique 200 est un plot (Fig. 1B, 2B, 3B, 4B, 6A). Le plot a une base ayant une surface et une hauteur.

La couche métallique 300 peut avoir la même surface que la surface de la base du plot ou de la deuxième extrémité des branches du peigne.

La couche métallique 300 peut avoir une surface supérieure à la surface de la base du plot. De manière très avantageuse, lors de l'étape b), plusieurs plots 200, 201 sont déposés sur la couche métallique 300 (Fig. 4B).

A l'issue de l'étape b), on obtient une structure thermoélectrique comprenant un substrat 100, une couche d'accroche 300 continue ou discontinue, par exemple, sous forme d'ilots, sur laquelle sont formés un ou plusieurs éléments thermoélectriques 200.

Après l'étape b), un recuit thermique peut être réalisé.

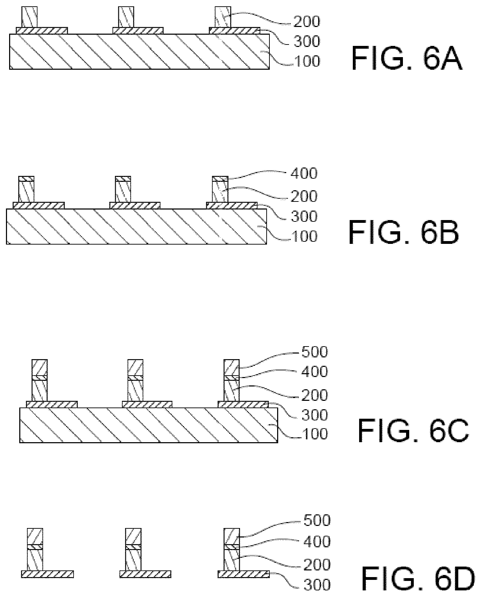

Avantageusement, entre l'étape b) et l'étape c), le procédé comprend une étape additionnelle au cours de laquelle on dépose sur l'élément thermoélectrique 200 une couche de métallisation intermédiaire 400 (Fig. 6B) puis un élément thermoélectrique additionnel 500 en un quatrième matériau (Fig. 6C). Le quatrième matériau est différent du deuxième matériau.

Lors de l'étape c), le substrat 100 retiré.

Le substrat 100 peut être retiré par découpe laser, jet d'eau, scie à fil, etc.

A l'issue de l'étape c), on obtient une structure thermoélectrique comprenant une couche d'accroche métallique 300 sur laquelle sont formés un ou plusieurs éléments thermoélectriques 200.

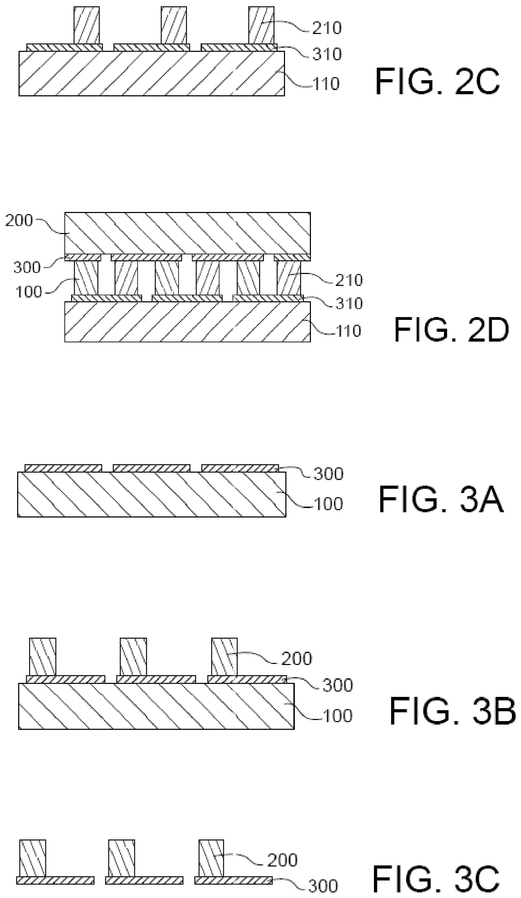

Ainsi, à l'issue de l'étape c), on obtient ainsi une première structure thermoélectrique. Avantageusement, le procédé de fabrication précédemment décrit est mis en œuvre pour fabriquer une deuxième structure thermoélectrique (Fig. 3D).

À l'issue de l'étape b), la structure comprend successivement un substrat 110, une couche métallique 310 et un ou plusieurs éléments thermoélectriques 210, 211. Le matériau thermoélectrique de cette structure est d'un dopage différent de celui de la première structure. Le substrat 110 est alors retiré pour avoir une deuxième structure thermoélectrique comprenant une couche métallique 310 et un ou plusieurs éléments thermoélectriques 210, 211 (Fig. 3D).

Les deux structures obtenues sont, avantageusement, assemblées et connectées électriquement pour former un dispositif thermoélectrique (Fig. 3E).

Il est possible de connecter les dispositifs en série et/ou en parallèle. Il est avantageux de combiner des connexions série et des connexions en parallèle afin d'optimiser les performances électriques de sortie du dispositif thermoélectrique fabriqué.

Les matériaux des couches métalliques 300, 310 des deux structures peuvent être identiques ou différents. Les matériaux des substrats 100, 110 utilisés peuvent être identiques ou différents.

L'invention est particulièrement intéressante pour fabriquer des modules thermoélectriques classiques, des substrats DBC, des modules thermoélectriques dit squelettes ou encore des plots thermoélectriques segmentés.

Le dispositif thermoélectrique obtenu peut fonctionner en mode Seebeck (i.e. le dispositif thermoélectrique est alors un générateur d'énergie électrique) ou en mode Peltier (i.e. le dispositif thermoélectrique est alors un générateur d'énergie thermique).

Nous allons maintenant décrire plus en détail différents modes de réalisation en faisant référence aux figures annexées.

Selon un premier mode de réalisation représenté aux Fig. 1A à 1C, le procédé selon l'invention comprend les étapes suivantes :

a) fournir un substrat 100 en un premier matériau, recouvert localement par une couche métallique 300 formant des ilots en troisième matériau,
b) déposer un plot thermoélectrique 200 en un deuxième matériau sur chaque ilot de la couche métallique 300, par fabrication additive, de préférence par SLS ou FLLP, la surface de la base des plots étant avantageusement de la même taille que la surface des ilots, c) retirer le substrat 100, moyennant quoi on obtient une structure thermoélectrique comprenant des plots thermoélectriques 200 recouverts par une couche métallique 300.

Ce premier mode de réalisation est avantageux car il permet de métalliser simplement les plots en déposant une couche métallique 300 sur le plateau de la machine de fabrication additive.

Selon un mode de réalisation hors invention représenté sur les Fig. 2A à 2D, il est décrit un procédé comprend les étapes suivantes :

a) fournir un substrat 100 en un premier matériau, recouvert localement par une couche métallique 300 formant des ilots en un troisième matériau,
b) déposer un plot thermoélectrique 200 en un deuxième matériau sur chaque ilot de la couche métallique 300, par fabrication additive, de préférence par SLS ou FLLP, la surface de la base des plots étant avantageusement inférieure à la surface des ilots, moyennant quoi on obtient une première structure thermoélectrique comprenant un substrat 100 recouvert localement par une couche métallique 300 formant des ilots, un plot thermoélectrique 200 étant disposé sur chaque ilot,
d) répéter les étapes a) et b) pour former une deuxième structure thermoélectrique comprenant un substrat 110 recouvert localement par une couche métallique 310 formant des ilots, chaque ilot étant recouvert par un plot thermoélectrique 210, le matériau thermoélectrique des plots thermoélectriques de la deuxième structure étant de conductivité opposée à celle du deuxième matériau de la première structure (Fig. 2C),
e) assembler et connecter électriquement la première structure thermoélectrique et la deuxième structure thermoélectrique (Fig. 2D).

Ce mode de réalisation hors invention permet de réaliser des modules squelettes.

Selon un deuxième mode de réalisation, représenté aux Fig. 3A à 3E, le procédé selon l'invention comprend les étapes suivantes :

a) fournir un substrat 100 en un premier matériau, recouvert localement par une couche métallique 300 formant des ilots en un troisième matériau,
b) déposer un plot thermoélectrique 200 en un deuxième matériau sur chaque ilot de la couche métallique 300, par fabrication additive, de préférence par SLS ou FLLP, la surface de la base des plots étant avantageusement inférieure à la surface des ilots,
c) retirer le substrat 100, moyennant quoi on obtient une première structure thermoélectrique comprenant des plots thermoélectriques 200 recouverts par une couche métallique 300,
d) répéter les étapes a) à c) pour former une deuxième structure thermoélectrique (Fig. 3D),
e) assembler et connecter électriquement la première structure thermoélectrique et la deuxième structure thermoélectrique (Fig. 3E).

Plus particulièrement, l'étape d) comprend ainsi les étapes suivantes :

- fournir un substrat 110 en un matériau pouvant être identique ou différent de celui du substrat 100 de la première structure, le substrat 110 étant recouvert localement par une couche métallique 310 formant des ilots,
- déposer un plot thermoélectrique 210 en un quatrième matériau sur chaque ilot de la couche métallique 310, par fabrication additive, de préférence par SLS ou FLLP, la surface de la base des plots étant avantageusement inférieure à la surface des ilots, les plots de la deuxième structure étant en un matériau thermoélectrique de conductivité opposée à la conductivité du matériau thermoélectrique de la première structure thermoélectrique,
- retirer le substrat 110, moyennant quoi on obtient une structure thermoélectrique comprenant des plots thermoélectriques 210, 211 recouverts par une couche métallique 310.

Selon ce deuxième mode de réalisation, on peut ainsi former des modules squelettes (Fig. 3E).

Selon un mode de réalisation (hors invention), représenté aux Fig. 4A à 4D, il est décrit un procédé comprend les étapes suivantes :

a) fournir un substrat 100 en un premier matériau, recouvert localement par une couche métallique 300 en un troisième matériau, formant des ilots,
b) déposer plusieurs plots thermoélectriques 200, 201, en un deuxième matériau sur chaque ilot de la couche d'accroche métallique 300, par fabrication additive, de préférence par SLS ou FLLP, moyennant quoi on obtient une structure comprenant un substrat 100 en un premier matériau recouvert par une couche métallique 300 formant des ilots, sur lesquels sont disposés plusieurs plots thermoélectriques 200, 201.

Le même procédé est mis en œuvre pour fabriquer une structure additionnelle comprenant un substrat 110, recouvert localement par une couche métallique 310 formant des ilots sur lesquels sont formés plusieurs plots thermoélectriques 210, 211 par fabrication additive (Fig. 4C). Les plots thermoélectriques 210, 211 de la deuxième structure ont une conductivité opposée à la conductivité des plots 200, 210 de la première structure. Les substrats 100, 110 des deux structures sont, avantageusement, des sur-plateaux en céramique, ayant par exemple une épaisseur entre 200 μm et quelques millimètres (par exemple 3 millimètres).

Les deux structures sont ensuite assemblées (Fig. 4D).

Ce mode de réalisation hors invention permet de combiner des connexions série / parallèle et ainsi optimiser les performances électriques de sortie. En effet, il est possible de relier électriquement à façon les différents plots thermoélectriques. Usuellement, tous les plots sont reliés électriquement en série. Mais ceci peut amener à obtenir des tensions de sortie élevées (de plusieurs volts), ce qui est incompatible avec une électronique associée ("power management unit") pour laquelle les tensions sont généralement de quelques volts. Ce mode de réalisation permet de relier certains plots en parallèle tout en diminuant la tension de sortie, et tout en maintenant la puissance générée.

Selon un troisième mode de réalisation représenté sur les Fig. 5A à 5C, le procédé selon l'invention comprend les étapes suivantes :

a) fournir un substrat 100 en un premier matériau, recouvert par une couche d'accroche métallique 300 en un troisième matériau,
b) former une pièce thermoélectrique 200 en forme de peigne, en un deuxième matériau sur la couche d'accroche métallique 300, par fabrication additive, de préférence par SLS ou FLLP,
c) retirer le substrat 100 et découper la couche d'accroche métallique 300 à la taille de la deuxième extrémité des branches, moyennant quoi on obtient un peigne 200 ayant des branches métallisées par une couche métallique 300.

Le même procédé est mis en œuvre pour fabriquer un autre peigne en un matériau de conductivité opposée au premier peigne. Les deux peignes sont ensuite assemblés. Selon un quatrième mode de réalisation représenté sur les Fig. 6A à 6D, le procédé selon l'invention comprend les étapes suivantes :

a) fournir un substrat 100 en un premier matériau, recouvert localement par une couche métallique 300, de manière à former des ilots métalliques,
b) déposer un plot thermoélectrique 200 en un deuxième matériau sur chaque ilot métallique recouvrant le substrat 100, par fabrication additive, de préférence par SLS ou FLLP, puis une couche de métallisation 400 et un autre élément thermoélectrique 500 en un autre matériau thermoélectrique,
c) retirer le substrat 100, moyennant quoi on obtient une structure thermoélectrique comprenant une couche métallique 300 recouverte par un premier plot thermoélectrique 200, une couche de métallisation 400 puis un second plot thermoélectrique 500.

Ce mode de réalisation est particulièrement avantageux pour fabriquer des plots thermoélectriques segmentés.

## Revendications

1. Procédé de fabrication d'une structure thermoélectrique comprenant les étapes suivantes :

a) fournir un substrat (100), recouvert complètement ou localement, par une couche métallique (300),
b) former un élément thermoélectrique (200) en un matériau thermoélectrique, sur la couche métallique (300), par fabrication additive, de préférence par frittage sélectif par laser ou par fusion laser sur lit de poudre,

**caractérisé en ce qu'**il comporte une étape c) ultérieure au cours de laquelle on retire le substrat (100), moyennant quoi on obtient une structure thermoélectrique comprenant la couche métallique (300) et l'élément thermoélectrique (200).

2. Procédé selon la revendication 1, **caractérisé en ce que** l'élément thermoélectrique (200) est un plot, ayant une base et une hauteur.

3. Procédé selon la revendication 1 ou 2, **caractérisé en ce que** la couche métallique (300) a une même surface que la surface de la base du plot.

4. Procédé selon la revendication 1 ou 2, **caractérisé en ce que** la couche métallique (300) a une surface supérieure à la surface de la base du plot.

5. Procédé selon l'une quelconque des revendications 1 à 4, **caractérisé en ce que**, lors de l'étape a), la couche métallique (300) recouvre localement le substrat (100) de manière à former une pluralité d'ilots et **en ce qu'**un élément ou plusieurs éléments thermoélectriques (200) sont déposés sur chaque ilot lors de l'étape b).

6. Procédé selon la revendication 1, **caractérisé en ce que** l'élément thermoélectrique (200) est une pièce ayant la forme d'un peigne délimitant une base et une pluralité de branches, sensiblement parallèles entre elles, s'étendant sensiblement orthogonalement à partir de la base, la pluralité de branches ayant une première extrémité et une deuxième extrémité, la première extrémité étant reliée à la base, et la deuxième extrémité de la pluralité de branches étant en contact avec la couche métallique (300).

7. Procédé selon l'une quelconque des revendications précédentes, **caractérisé en ce que** le matériau thermoélectrique est choisi parmi Si, SiGe, $Bi_2Te_3$, Half-Heusler et Skutterudites.

8. Procédé selon l'une quelconque des revendications précédentes, **caractérisé en ce que** le substrat (100) est de l'acier 316L, l'aluminium, le titane, un alliage CuZr, une céramique ou du graphite.

9. Procédé selon l'une quelconque des revendications précédentes, **caractérisé en ce que** la couche métallique (300) est en un matériau choisi parmi Al, Ti, Cu, Au et Ni.

## Patentansprüche

1. Verfahren zur Fertigung einer thermoelektrischen Struktur, das die folgenden Schritte umfasst:

   a) Bereitstellen eines Substrats (100), das vollständig oder lokal mit einer Metallschicht (300) bedeckt ist,
   b) Bilden eines thermoelektrischen Elements (200) aus einem thermoelektrischen Material auf der Metallschicht (300) durch additive Fertigung, vorzugsweise durch selektives Lasersintern oder Laserschmelzen auf Pulverbett,

   **dadurch gekennzeichnet, dass** es einen nachfolgenden Schritt c) aufweist, bei dem das Substrat (100) entfernt wird, wodurch eine thermoelektrische Struktur erhalten wird, die die Metallschicht (300) und das thermoelektrische Element (200) umfasst.

2. Verfahren nach Anspruch 1, **dadurch gekennzeichnet, dass** das thermoelektrische Element (200) ein Stift ist, der eine Basis und eine Höhe hat.

3. Verfahren nach Anspruch 1 oder 2, **dadurch gekennzeichnet, dass** die Metallschicht (300) die gleiche Oberfläche wie die Oberfläche der Basis des Stifts hat.

4. Verfahren nach Anspruch 1 oder 2, **dadurch gekennzeichnet, dass** die Metallschicht (300) eine größere Oberfläche als die Oberfläche der Basis des Stifts hat.

5. Verfahren nach einem der Ansprüche 1 bis 4, **dadurch gekennzeichnet, dass** in Schritt a) die Metallschicht (300) das Substrat (100) lokal so bedeckt, dass eine Vielzahl von Inseln gebildet wird, und dass in Schritt b) ein oder mehrere thermoelektrische Elemente (200) auf jeder Insel aufgebracht werden.

6. Verfahren nach Anspruch 1, **dadurch gekennzeichnet, dass** das thermoelektrische Element (200) ein kämmförmiges Teil ist, das eine Basis und eine Vielzahl von im Wesentlichen parallel zueinander liegenden Armen begrenzt, die sich im Wesentlichen orthogonal von der Basis aus erstrecken, wobei die Vielzahl von Armen ein erstes Ende und ein zweites Ende haben, wobei das erste Ende mit der Basis verbunden ist und das zweite Ende der Vielzahl von Armen in Kontakt mit der Metallschicht (300) steht.

7. Verfahren nach einem der vorhergehenden Ansprüche, **dadurch gekennzeichnet, dass** das thermoelektrische Material aus Si, SiGe, $Bi_2Te_3$, Half-Heusler und Skutterudites ausgewählt ist.

8. Verfahren nach einem der vorhergehenden Ansprüche, **dadurch gekennzeichnet, dass** das Substrat (100) aus Stahl 316L, Aluminium, Titan, einer CuZr-Legierung, Keramik oder Graphit besteht.

9. Verfahren nach einem der vorhergehenden Ansprüche, **dadurch gekennzeichnet, dass** die Metallschicht (300) aus einem Material besteht, das aus Al, Ti, Cu, Au und Ni ausgewählt ist.

## Claims

1. Method for manufacturing a thermoelectric structure comprising the following steps:

   a) providing a substrate (100), covered completely or locally with a metal layer (300),
   b) forming a thermoelectric element (200) made from a thermoelectric material on the metal layer (300), by additive manufacturing, preferably by selective laser sintering or by powder bed laser fusion,

   **characterised in that** it includes a subsequent step c) during which the substrate (100) is removed, whereby a thermoelectric structure is obtained comprising the metal layer (300) and the thermoelectric element (200).

2. Method according to claim 1, **characterised in that** the thermoelectric element (200) is a pin, having a base and a height.

3. Method according to claim 1 or 2, **characterised in that** the metal layer (300) has the same surface area as the surface area of the base of the pin.

4. Method according to claim 1 or 2, **characterised in that** the metal layer (300) has a surface area greater than the surface area of the base of the pin.

5. Method according to any one of claims 1 to 4, **characterised in that**, in step a), the metal layer (300) locally covers the substrate (100) so as to form a plurality of islands and **in that** a thermoelectric element or a plurality of thermoelectric elements (200) are deposited on each island during step b).

6. Method according to claim 1, **characterised in that** the thermoelectric element (200) is a part in the form of a comb delimiting a base and a plurality of arms, substantially parallel to each other, extending substantially orthogonally from the base, the plurality of arms having a first end and a second end, the first end being connected to the base, and the second end of the plurality of arms being in contact with the metal layer (300).

7. Method according to any one of the preceding claims, **characterised in that** the thermoelectric material is selected from Si, SiGe, $Bi_2Te_3$, Half-Heusler and Skutterudites.

8. Method according to any one of the preceding claims, **characterised in that** the substrate (100) is 316L steel, aluminium, titanium, a CuZr alloy, a ceramic or graphite.

9. Method according to any one of the preceding claims, **characterised in that** the metal layer (300) is made from a material selected from Al, Ti, Cu, Au and Ni.

FIG. 1A

FIG. 1B

FIG. 1C

FIG. 2A

FIG. 2B

FIG. 2C

FIG. 2D

FIG. 3A

FIG. 3B

FIG. 3C

FIG. 3D

210
310

FIG. 3E

310
210
200
300

FIG. 4A

300
100

FIG. 4B

201
200
300
100

FIG. 4C

211
210
310
110

FIG. 4D

FIG. 5A

FIG. 5B

FIG. 5C

FIG. 6A

FIG. 6B

FIG. 6C

FIG. 6D

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2020066948 A1